(19) Europäisches Patentamt / European Patent Office / Office européen des brevets

(11) **EP 2 732 548 B1**

(12) **FASCICULE DE BREVET EUROPEEN**

(45) Date de publication et mention de la délivrance du brevet:
**28.08.2019 Bulletin 2019/35**

(21) Numéro de dépôt: **12735300.1**

(22) Date de dépôt: **12.07.2012**

(51) Int Cl.:
*H03B 15/00* [(2006.01)]    *H03C 3/09* [(2006.01)]

(86) Numéro de dépôt international:
**PCT/EP2012/063725**

(87) Numéro de publication internationale:
**WO 2013/007797 (17.01.2013 Gazette 2013/03)**

(54) **OSCILLATEUR SPINTRONIQUE ET UTILISATION DE CELUI-CI DANS DES DISPOSITIFS RADIOFRÉQUENCE**

SPINTRONISCHER OSZILLATOR UND SEINE VERWENDUNG FÜR HOCHFREQUENZVORRICHTUNGEN

SPINTRONIC OSCILLATOR, AND USE THEREOF IN RADIOFREQUENCY DEVICES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.07.2011 FR 1102192**

(43) Date de publication de la demande:
**21.05.2014 Bulletin 2014/21**

(73) Titulaires:
• **THALES**
  **92200 Neuilly-sur-Seine (FR)**
• **Centre National de la Recherche Scientifique (C.N.R.S.)**
  **75016 Paris (FR)**
• **Université Paris-Sud**
  **91405 Orsay Cedex (FR)**

(72) Inventeurs:
• **LOCATELLI, Nicolas**
  **F-92160 Antony (FR)**
• **MARCILHAC, Bruno**
  **F-91620 Nozay (FR)**
• **MAGE, Jean-Claude**
  **F-91120 Palaiseau (FR)**
• **CROS, Vincent**
  **F-75011 Paris (FR)**
• **KHVALKOVSKIY, Alexey Vasilyevich**
  **F-92100 Boulogne Billancourt (FR)**
• **GROLLIER, Julie**
  **F-75013 Paris (FR)**

(74) Mandataire: **Lavoix**
  **2, place d'Estienne d'Orves**
  **75441 Paris Cedex 09 (FR)**

(56) Documents cités:
**FR-A1- 2 944 384**

• **LOCATELLI N ET AL: "Dynamics of two coupled vortices in a spin valve nanopillar excited by spin transfer torque", APPLIED PHYSICS LETTERS, AIP, AMERICAN INSTITUTE OF PHYSICS, MELVILLE, NY, US, vol. 98, no. 6, 7 février 2011 (2011-02-07), pages 62501-62501, XP012139441, ISSN: 0003-6951, DOI: 10.1063/1.3553771**
• **WINTZ S ET AL: "Direct observation of antiferromagnetically oriented spin vortex states in magnetic multilayer elements", APPLIED PHYSICS LETTERS, AIP, AMERICAN INSTITUTE OF PHYSICS, MELVILLE, NY, US, vol. 98, no. 23, 9 juin 2011 (2011-06-09), pages 232511-232511, XP012140969, ISSN: 0003-6951, DOI: 10.1063/1.3597297**
• **GROLLIER J ET AL: "Synchronization of spin-transfer oscillators driven by stimulated microwave currents", PHYSICAL REVIEW. B, CONDENSED MATTER AND MATERIALS PHYSICS, AMERICAN INSTITUTE OF PHYSICS, WOODBURY, NY, US, vol. 73, 24 février 2006 (2006-02-24), pages 60409-1, XP008132021, ISSN: 1098-0121**

- MANCOFF F B ET AL: "Angular dependence of spin-transfer switching in a magnetic nanostructure", APPLIED PHYSICS LETTERS, AIP, AMERICAN INSTITUTE OF PHYSICS, MELVILLE, NY, US, vol. 83, no. 8, 25 août 2003 (2003-08-25), pages 1596-1598, XP012035888, ISSN: 0003-6951, DOI: 10.1063/1.1604936
- ZABEL ET AL: "Progress in spintronics", SUPERLATTICES AND MICROSTRUCTURES, ACADEMIC PRESS, LONDON, GB, vol. 46, no. 4, 1 octobre 2009 (2009-10-01), pages 541-553, XP026611559, ISSN: 0749-6036, DOI: 10.1016/J.SPMI.2009.07.008 [extrait le 2009-07-31]
- KHVALKOVSKIY A ET AL: "Nonuniformity of a planar polarizer for spin-transfer-induced vortex oscillations at zero field", APPLIED PHYSICS LETTERS, AIP, AMERICAN INSTITUTE OF PHYSICS, MELVILLE, NY, US, vol. 96, no. 21, 28 mai 2010 (2010-05-28), pages 212507-212507, XP012131333, ISSN: 0003-6951, DOI: 10.1063/1.3441405
- JUN SU-HYEONG ET AL: "Nonlinear motion of coupled magnetic vortices in ferromagnetic/nonmagnetic/ferromagnetic trilayer", APPLIED PHYSICS LETTERS, A I P PUBLISHING LLC, US, vol. 95, no. 14, 9 October 2009 (2009-10-09), pages 142509-142509, XP012125962, ISSN: 0003-6951, DOI: 10.1063/1.3243985
- DANIEL E. B?RGLER ET AL: "Injection locking of single-vortex and double-vortex spin-torque oscillators", PROCEEDINGS OF SPIE, 1 January 2011 (2011-01-01), pages 810018-810018-9, XP055020338, ISSN: 0277-786X, DOI: 10.1117/12.892395

**Description**

La présente invention a pour domaine celui des oscillateurs magnétiques, aussi dénommés oscillateurs spintroniques, pouvant être utilisés dans des systèmes de synthèse de fréquence, de mélange de fréquences, de détection de fréquence, etc.

De manière générale, les dispositifs d'émission/réception d'ondes radioélectriques intègrent tous un étage permettant le mélange d'un signal reçu, avec un signal de référence issu d'un synthétiseur de fréquence. Cet étage de mélange est souvent composé d'un mélangeur et d'un oscillateur local intégré dans une boucle à verrouillage de phase (PLL pour « Phase Locked Loop » en anglais). Un tel oscillateur local met en oeuvre une technologie choisie parmi plusieurs technologies possibles (quartz, ondes acoustiques, circuit LC, oscillateur ring, etc.) en fonction des caractéristiques performance/coût recherchées pour le dispositif.

Mais, quelle que soit la technologie choisie, les oscillateurs connus conduisent à des dispositifs radiofréquences présentant deux problèmes majeurs : d'une part, le volume du dispositif qui reste trop encombrant ; d'autre part, sa plage d'accord en fréquence qui est relativement restreinte (inférieure à l'octave). En particulier, face à la multiplication des standards de télécommunication, une plage d'accord limitée représente un verrou particulièrement fort, empêchant d'envisager des dispositifs "multi-standards" et/ou opportunistes.

Par conséquent, des dispositifs radiofréquences fortement intégrés et à bande de fréquences large, indispensables pour poursuivre la miniaturisation des circuits radiofréquences les intégrant, ne peuvent être développés que sur la base de nouveaux types d'oscillateur.

Or, il a été récemment proposé un nouveau type d'oscillateur, dit magnétique. Le fonctionnement d'un oscillateur magnétique est fondé sur le phénomène physique de couple de transfert de spin.

Le phénomène de couple de transfert de spin se manifeste dans des composants présentant une structure comportant successivement une première couche ferromagnétique (de quelques nanomètres à quelques dizaines de nanomètres d'épaisseur), une couche non magnétique intermédiaire et une seconde couche ferromagnétique.

En particulier, ce phénomène de couple de transfert de spin entre les porteurs de charges (électrons ou trous) existe dans des structures dites nanopiliers constituées d'une première couche fine ferromagnétique (typiquement de quelques nm à quelques dizaines de nm), d'une couche non magnétique intermédiaire et d'une seconde couche fine ferromagnétique, ces couches ayant une dimension réduite dans un plan orthogonal à la direction d'empilement des couches. Typiquement, un nanopilier est un cylindre dont l'axe correspond à la direction d'empilement des couches et dont le rayon est typiquement de quelques dizaines de nanomètres.

L'injection d'un courant au travers de cette structure permet de générer un courant polarisé en spin. L'interaction entre les spins des porteurs de charges (électrons ou trous) du courant polarisé en spin et l'aimantation du matériau ferromagnétique de l'une des couches magnétiques, par exemple la seconde couche, se traduit par un couple, dit "couple de transfert de spin", lié à la relaxation de tout ou partie de cette polarisation en spin sur l'aimantation.

Le phénomène de transfert de spin permet ainsi de manipuler l'aimantation de la seconde couche sans application de champ magnétique, mais par application d'un courant d'alimentation ayant été polarisé en spin. C'est ce principe qui est mis en oeuvre dans les dernières générations de mémoires non volatiles MRAM (« Magnetic Random Access Memory » en anglais) pour commuter la configuration magnétique dans laquelle est stockée l'information magnétique.

Le phénomène de couple de transfert de spin induit donc une modification de la configuration magnétique. Celle-ci qui peut être détecté par une variation de la résistance électrique du nanopilier. En effet, la résistance électrique du nanopilier dépend de l'orientation de l'aimantation de la seconde couche par rapport à celle de la première couche. Cet effet magnétorésistif est connu sous le nom de magnétorésistance géante (GMR) dans des nanopiliers tout métal, et magnétorésistance tunnel (TMR), dans des nanopiliers comportant des jonctions tunnel.

La configuration magnétique d'une couche ferromagnétique dans un nanopilier ayant des dimensions nanométriques est un mono domaine magnétique. En effet l'introduction d'une paroi entre deux domaines présentant des aimantations différentes est trop coûteuse énergétiquement, de sorte qu'une telle configuration magnétique ne se présente pas.

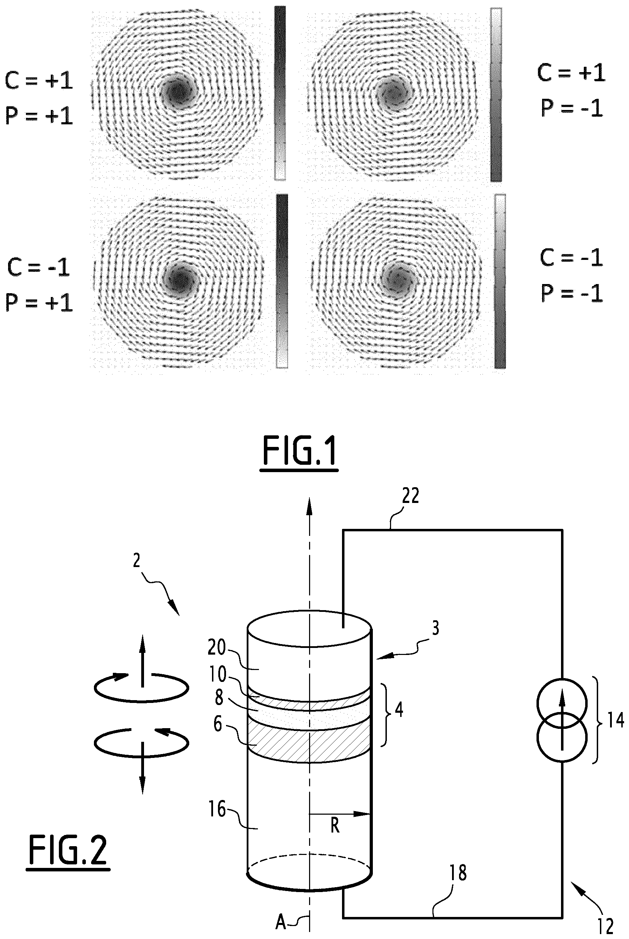

En revanche, la configuration magnétique rémanente, qui est la configuration stable résultant d'une compétition entre l'énergie d'échange et les énergies magnétostatiques, n'est pas forcément une configuration dans laquelle l'aimantation est uniforme. Un autre type possible de configuration magnétique rémanente correspond à une aimantation dite « en vortex ». Dans une telle configuration, les moments magnétiques, essentiellement planaires, s'enroulent autour du centre de la couche ferromagnétique, sauf dans une région entourant le centre de la couche, appelée coeur de vortex et ayant un rayon de l'ordre de grandeur de la longueur d'échange ($L_{EX}$) du matériau (par exemple 5-6 nm dans le Co ou l'alliage NiFe), où les moments magnétiques de la configuration magnétique pointent hors du plan de la couche, vers le haut ou vers le bas. La direction dans laquelle pointe l'aimantation du coeur définit la polarité du vortex (P=+/- 1). Un second paramètre du vortex est sa chiralité, qui correspond au sens d'enroulement des moments magnétiques autour du centre de la couche et qui peut prendre deux valeurs : C = + 1 lorsqu'ils s'enroulent dans le sens des aiguilles d'une montre, ou C = - 1 lorsqu'ils s'enroulent dans le sens inverse. Une couche ferromagnétique peut être dans l'une des quatre configurations en vortex possibles correspondant à une valeur de la polarité et à une valeur de la chiralité. Ces quatre configurations sont représentées sur la figure 1.

Fort de cette constatation, la demande de brevet US 2009/0117370 A1 décrit, dans le domaine des mémoires magnétiques non volatiles, l'utilisation d'un nanopilier comportant un motif comprenant deux couches magnétiques, chacune d'elles ayant une configuration magnétique rémanente en vortex. Les quatre configurations de chiralités des vortex permettent de réaliser une mémoire à quatre états. Ce brevet US n'utilise pas la polarité des vortex comme degré de stockage de l'information. Grâce aux effets de magnétorésistance géante ou tunnel, la mesure de la résistance totale du nanopilier permet de déterminer l'état courant de la mémoire.

Outre les effets permettant de modifier les configurations magnétiques statiques venant d'être présentés, le phénomène de couple de transfert de spin peut également induire (dans certaines conditions liées au champ magnétique extérieur dans lequel le nanopilier est plongé et à l'intensité du courant d'alimentation injecté à travers celui-ci) une oscillation entrenue de la configuration magnétique de l'une ou des deux couches magnétiques. Cette oscillation correspond à l'excitation de modes dynamiques liés à la configuration magnétique statique (uniforme, C-state, vortex, ...), dont les fréquences caractéristiques dépendent des paramètres liés aux choix des matériaux constitutifs de ces couches magnétiques (aimantation à saturation, longueur d'échange, coefficient d'amortissement, ...), ainsi que des dimensions (rayon et épaisseur pour des couches en forme de disque) et de la géométrie du pilier.

Grâce à l'effet magnétorésistif décrit précédemment, toute oscillation de tout ou partie de l'aimantation de la structure est susceptible d'entrainer une variation de la résistance du pilier à une fréquence égale à celle de l'oscillation de l'aimantation. On obtient alors aux bornes du pilier une tension oscillante, dont le spectre fréquentiel reflète celui des modes magnétiques excités de la structure.

Cet effet d'oscillation sera par la suite exprimé à travers la puissance hyperfréquence émise par le nanopilier, qui correspond au produit de la tension aux bornes du nanopilier, par l'intensité du courant d'alimentation injecté à travers celui-ci.

Les fréquences caractéristiques sont donc spécifiques du nanopilier et peuvent être modulées par action sur la configuration magnétique statique. Elles dépendent ainsi de l'amplitude du champ extérieur, de l'intensité du courant d'alimentation (typiquement de l'ordre du milliampère, ce qui correspond à des densités de courant de l'ordre de quelques $10^7$ A/cm$^2$ à travers une section du nanopilier), des dimensions des couches du nanopilier. La gamme des fréquences caractéristiques accessibles est comprise entre quelques centaines de MHz et quelques dizaines de GHz.

Un composant constitué d'un tel nanopilier et des moyens adaptés d'injection d'un courant d'alimentation et d'application d'un champ magnétique extérieur pour, par mise en oeuvre du phénomène de couple de transfert de spin, placer le nanopilier dans un état excité correspondant à une oscillation entretenue de la configuration magnétique de l'une ou bien de l'ensemble des deux couches magnétiques, constitue un oscillateur magnétique.

Ainsi, par exemple, dans l'article de Locatelli et al. "Dynamics of two coupled vortices in a spin valve nanopillar excited by spin transfer torque", APPLIED PHYSICS LETTERS, AIP, AMERICAN INSTITUTE OF PHYSICS, MELVILLE, NY, US, vol. 98, no. 6, 7 février 2011 (2011-02-07), pages 62501-62501, il est prévu l'application d'un courant d'alimentation pour la nucléation de vortex dans les première et seconde couches de l'oscillateur dont la configuration magnétique rémanente est uniforme.

En comparaison des autres technologies existantes, un tel oscillateur magnétique présente plusieurs avantages tels que des dimensions réduites, une grande plage d'accord accessible grâce à la variation de l'amplitude du courant d'alimentation et d'un champ magnétique extérieur adaptées, une rapidité du changement du point de fonctionnement en fréquence (par exemple par des variations adaptées de l'intensité du courant d'alimentation) et une insensibilité aux radiations électromagnétiques.

En revanche, plusieurs verrous technologiques existent :

- l'application d'un champ magnétique extérieur est, en général, nécessaire, pour atteindre le régime dans lequel le couple de transfert de spin induit une oscillation entretenue plutôt qu'une commutation.
- l'amplitude des oscillations relative entre les aimantations des deux couches reste réduite. Par conséquent, la puissance électrique obtenue par l'oscillation est très faible, de l'ordre du picowatt (pW).
- les dimensions nanométriques des oscillateurs magnétiques font qu'ils sont particulièrement sensibles aux fluctuations thermiques. Ceci se traduit par l'existence d'un bruit de phase et d'un bruit d'amplitude qui affectent le signal de puissance. Ce dernier présente une largeur de raie importante et l'oscillateur magnétique correspondant se caractérise par des facteurs de qualité faibles.
- pour initier, via le phénomène de couple de transfert de spin, un des modes dynamiques de l'aimantation, l'intensité du courant d'alimentation doit atteindre un seuil élevé, propre à compenser les phénomènes dissipatifs liés à la relaxation magnétique. L'intensité du courant d'alimentation doit être telle que la densité de courant à travers une section du nanopilier soit d'environ $10^7$ A/cm$^2$.
- même si la fenêtre d'accord d'un oscillateur magnétique, c'est-à-dire la gamme de fréquences sur laquelle il est susceptible de fonctionner en fonction de l'intensité du courant d'alimentation, est large (entre quelques dizaines de MHz et quelques dizaines de GHz), la dépendance de la fréquence des oscillations en fonction de l'intensité du courant d'alimentation présente un comportement complexe qui rend l'utilisation de tels oscillateurs magnétiques compliquée lorsqu'il s'agit de les intégrer dans des dispositifs d'émission/réception radioélectriques.

Par ailleurs, le document Wintz et al., "Direct observation of antiferromagneticaliy oriented spin vortex states in magnetic multilayer elements", APPLIED PHYSICS LETTERS, AIP, AMERICAN INSTITUTE OF PHYSICS, MELVILLE, NY, US, vol. 98, no. 23, 9 juin 2011 (2011-06-09), pages 232511-232511, divulgue l'observation directe, par des effets optiques différentiels, du couplage entre les chiralités de deux vortex dans une structure comportant une première couche ferromagnétique, une couche intermédiaire non magnétique et une seconde couche ferromagnétique.

Le document Su-Hyeong et al., "Nonlinear motion of coupled magnetic vortices in ferromagnetic/nonmagnetic/ferromagnetic trilayer", APPLIED PHYSICS LETTERS, A I P PUBLISHING LLC, US, vol. 95, no. 14, 9 octobre 2009 (2009-10-09), pages 142509-142509, présente des simulations numériques d'une dynamique non linéaire entre deux vortex couplés dans une structure faite de deux couches ferromagnétiques séparées par une couche intermédiaire non magnétique.

Le document Buergler et al. "Injection locking of single-vortex and double-vortex spin-torque oscillators", PROCEEDINGS OF SPIE, 1 janvier 2011 (2011-01-01), pages 810018-810018-9, étudie le comportement dynamique en régime forcé d'un oscillateur spintronique à simple et à double vortex.

L'invention a donc pour but de palier aux problèmes précités.

Pour cela l'invention a pour objet un oscillateur magnétique, un dispositif et un procédé conformes aux revendications.

L'invention sera mieux comprise à la lecture de la description qui va suivre, donnée uniquement à titre d'exemple non limitatif et faite en se référant aux dessins annexés, sur lesquels :

- la figure 1 est une représentation des quatre formes de vortex associées à une configuration magnétique en vortex d'une couche ferromagnétique ;
- la figure 2 est une représentation schématique d'un oscillateur magnétique selon la présente l'invention ;
- la figure 3 est un diagramme des états fondamentaux représentant les configurations magnétiques rémanentes d'une couche ferromagnétique en forme de disque, en fonction des caractéristiques géométriques normalisées par la longueur d'échange $L_{EX}$ du matériau de la couche considérée ;
- la figure 4 est une représentation schématique de configurations magnétiques rémanentes en vortex pour les première et seconde couches ferromagnétiques présentant des polarités parallèles (cas défavorable) d'un oscillateur magnétique ;
- la figure 5 est une représentation schématique de configurations magnétiques rémanentes en vortex pour les première et seconde couches ferromagnétiques présentant des polarités aintiparallèles (cas favorable) de l'oscillateur magnétique selon l'invention ;
- la figure 6 est un graphe représentant les variations typiques de la fréquence propre de l'oscillateur magnétique de la figure 2 en fonction de la densité du courant d'alimentation injecté (résultats obtenus pour une simulation numérique d'un pilier de diamètre 200 nm, avec un empilement NiFe(15 nm)/Cu(10 nm)/NiFe(4 nm));
- La figure 7 est une représentation schématique d'une première variante de réalisation de l'oscillateur magnétique selon l'invention, le nanopilier comportant un motif ayant une troisième couche magnétique séparée, soit de la première couche, soit de la second couche ferromagnétique, par une couche non magnétique isolante ;
- la figure 8 est une représentation schématique d'une seconde variante de réalisation de l'oscillateur selon l'invention, le nanopilier étant réalisé par l'empilement de plusieurs motifs, chaque motif reprenant celui du nanopilier de l'oscillateur de la figure 2 ; et,
- la figure 9 est une représentation schématique d'une troisième variante de réalisation de l'oscillateur selon l'invention constitué d'un réseau à deux dimensions de nanopiliers, chaque nanopilier étant conforme à celui de l'oscillateur de la figure 2.

Un premier mode de réalisation de l'oscillateur magnétique selon l'invention est représenté schématiquement à la Figure 2. L'oscillateur magnétique 2 comporte un nanopilier 3 et des moyens d'injection d'un courant d'alimentation 12 à travers le nanopilier 3.

Le nanopilier 3 comporte un motif 4. Celui-ci est constitué par, superposées le long d'une direction A d'empilement des couches, d'une première couche 6 en un matériau ferromagnétique, d'une couche intermédiaire 8 en un matériau non magnétique, et d'une seconde couche 10 en un matériau ferromagnétique.

A chacune de ses extrémités, le nanopilier 3 comporte respectivement des couches inférieure 16 et supérieure 20 qui sont disposées de part et d'autre du motif 4 et constituent des contacts permettant l'injection d'un courant d'alimentation à travers les couches 6, 8 et 10.

Les matériaux ferromagnétiques envisagés pour les couches magnétiques sont le fer Fe, le cobalt Co, le nickel Ni et les alliages ferromagnétiques comprenant au moins un de ces éléments (CoFeB par exemple), ainsi que les matériaux Heusler, les oxydes magnétiques ou les semi-conducteurs magnétiques. Le matériau ferromagnétique de la seconde couche 10 n'est pas forcément identique à celui de la première couche 6.

La couche intermédiaire 8 non magnétique est une couche conductrice, réalisée par exemple en cuivre Cu, en or Au, etc., ou une couche isolante, réalisée en $Al_2O_3$, MgO, $SrTiO_3$, etc.

Les couches 6, 8 et 10 forment respectivement des disques ayant une épaisseur comprise entre quelques dixièmes et quelques dizaines de nanomètres, et un rayon R de quelques centaines de nanomètres, notamment 200 nm.

L'épaisseur de la première couche 6 est de 15 nm. Plus généralement, elle est comprise entre 0,2 et 30 nm.

L'épaisseur de la couche intermédiaire 8 est de 10 nm. Plus généralement, elle est de comprise entre 0,5 et 20 nm.

L'épaisseur de la seconde couche 10 est de 4 nm. Plus généralement, elle est comprise entre 0,1 et 30 nm.

Les couches inférieure et supérieure 16 et 20 sont réalisées en un matériau présentant de bonnes propriétés de conduction électrique, tel que le cuivre ou l'or. Ces couches possèdent une épaisseur d'environ 25 nm. Elles ont de préférence un rayon similaire à celui des couches constitutives du motif 4.

Les moyens 12 propres à permettre l'injection d'un courant d'alimentation à travers le nanopilier 3 sont représentés schématiquement sur la figure 2 par une source de courant 14 réglable en intensité et en fréquence, et des électrodes 18 et 22.

Ces électrodes permettent de connecter électriquement les couches inférieure et supérieure 16 et 20 aux bornes de la source 14 pour l'injection du courant d'alimentation d'une part et à un moyen de mesure (non représenté) pour la détermination de la différence de potentiel électrique à la traversée du nanopilier 3, c'est-à-dire entre les couches inférieure et supérieure 16 et 20, d'autre part.

Les première et seconde couches ferromagnétiques 6 et 10 sont caractérisées par des états rémanents spécifiques. Les première et seconde couches 6 et 10 du motif 4 du nanopilier 3 présentent respectivement une configuration magnétique rémanente en vortex. Seules sont retenues les formes de vortex telles que la polarité du vortex de la première couche 6 soit opposée à la polarité du vortex de la seconde couche 10. Ceci conduit à l'établissement d'un couplage magnétique répulsif entre les coeurs des vortex des deux couches, à condition que le matériau et l'épaisseur de la couche intermédiaire 8 soient également adaptés. Dans ces conditions, des oscillations de la puissance émise par le nanopilier 3 apparaissent, quelle que soit l'intensité du courant d'alimentation injecté, c'est-à-dire un seuil en courant ramené à zéro.

Le sens et l'intérêt de ces caractéristiques vont maintenant être explicités progressivement.

Une couche ferromagnétique peut être dans différentes configurations magnétiques en fonction de la valeur de variables telles que les dimensions de la couche, l'intensité du courant d'alimentation, l'amplitude du champ magnétique extérieur, la température, etc.

La configuration magnétique rémanente est la configuration magnétique stable de la couche ferromagnétique lorsque le champ magnétique extérieur et l'intensité du courant d'alimentation sont nuls.

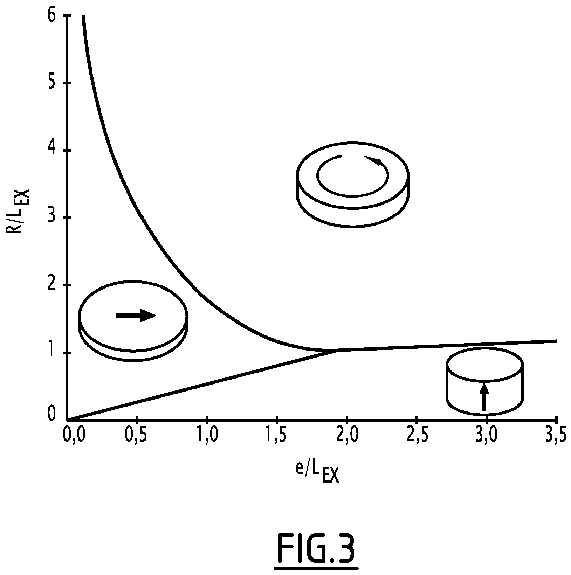

Pour une couche en forme de disque, la configuration magnétique rémanente ne dépend que des valeurs des variables d'épaisseur et de rayon de cette couche. Sur la figure 3, un diagramme caractéristique des configurations magnétiques rémanentes est représenté en fonction de l'épaisseur e et du rayon R de la couche, normalisés par la longueur d'échange $L_{EX}$ du matériau de la couche considérée. Ce diagramme présente trois domaines correspondant respectivement à une aimantation uniforme selon une direction orthogonale à la direction A, une aimantation uniforme selon la direction A et une aimantation en vortex.

Ainsi, dans le présent oscillateur magnétique, les première et seconde couches 6 et 10 sont telles que leur configuration magnétique rémanente respective corresponde à une configuration magnétique en vortex.

Sur la figure 1, ont été représentées, en vue de dessus, les quatre configurations en vortex possibles pour une couche ferromagnétique. Comme indiqué en introduction, une forme de vortex magnétique est caractérisée par un paramètre de chiralité C et un paramètre de polarité P.

Parmi les seize configurations magnétiques rémanentes (ou présentes sous l'influence d'un paramètre extérieur, tels que le courant) du nanopilier 6 (quatre pour la première couche 6 et quatre configurations en vortex pour la seconde couche 10), seules certaines configurations magnétiques rémanentes sont retenues pour l'obtention du présent oscillateur magnétique. Il s'agit des configurations magnétiques dans lesquelles les polarités des vortex des première et seconde couches sont opposées, quelles que soient par ailleurs les chiralités de ces deux vortex.

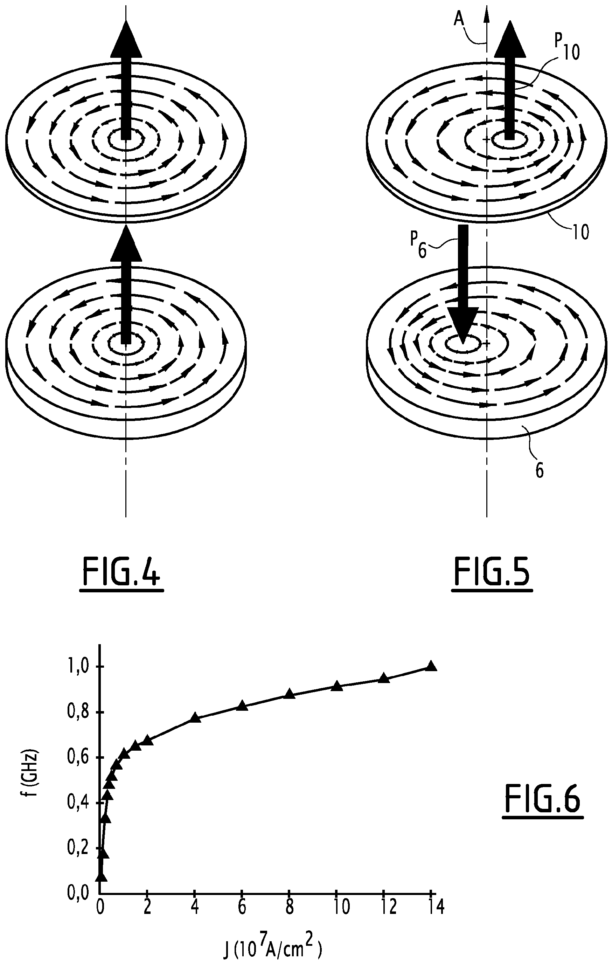

Sur la figure 4, qui ne correspond pas à l'oscillateur selon l'invention, les vortex des deux couches conduisent à une configuration magnétique rémanente du nanopilier non favorable, car dans ce cas, le courant seuil pour obtenir les oscillations ne peut pas tendre vers zéro et vaut typiquement quelques $10^7$ A/cm$^2$.

Sur la figure 5, en revanche, les vortex des première et seconde couches conduisent à une configuration magnétique rémanente du nanopilier qui convient pour le présent oscillateur. En effet, dans ce dernier cas, l'aimantation du coeur du vortex de la première couche 6 est orientée vers le bas ($P_6 = -1$), tandis que l'aimantation du coeur du vortex de la seconde couche 10 est orientée vers le haut ($P_{10} = +1$). L'autre configuration magnétique rémanente acceptable pour le nanopilier 3 correspond à $P_6 = +1$ et $P_{10} = -1$.

De manière générale, le couplage magnétique entre les deux vortex a pour conséquence que le système à considérer est une paire de vortex couplés ayant ses modes propres d'oscillation présentant des caractéristiques distinctes de celles où les deux couches magnétiques sont isolées l'une de l'autre. Dans l'état rémanent du nanopilier, le couplage magnétique entre les vortex est dominé par un terme d'interaction de type dipolaire entre les aimantations des coeurs des deux vortex.

En sélectionnant spécifiquement des polarités opposées pour ces deux vortex, le couplage magnétique est répulsif. Ce couplage a ainsi tendance à repousser le coeur du vortex de la première couche 6 par rapport au coeur du vortex de la seconde couche 10, de sorte que, dans la configuration rémanente du nanopilier, les coeurs des deux vortex sont décentrés par rapport à la direction A, comme cela est représenté sur la figure 5.

Par l'application d'un courant d'alimentation, même d'intensité faible, et grâce au phénomène de couple de transfert de spin, cette paire de vortex est excitée de sorte que les vortex sont mis en mouvement. Dans cet état excité de la paire de vortex, correspondant à un mode dynamique de la paire de vortex, les vortex ont des mouvements gyrotropiques corrélés entre eux. Les trajectoires décrites par chacun des deux vortex sont sensiblement circulaires et centrées autour de la direction A. A chaque état excité correspond une valeur de la fréquence de révolution autour de la direction A.

Ces mouvements gyrotropiques corrélés des deux vortex sont à l'origine d'une variation de la résistance totale du nanopilier : celle-ci varie périodiquement à une fréquence propre caractéristique de l'état excité dans lequel se trouve la paire de vortex.

Il est à noter que si les deux vortex ont la même polarité, le couplage magnétique entre les deux coeurs est attractif, ce qui tend à stabiliser les deux coeurs de vortex sur l'axe A du nanopilier. Le confinement des vortex étant alors augmenté, il faut un courant d'alimentation non nul pour exciter un mode dynamique de cet ensemble de vortex.

Ainsi, pour que les deux vortex soient couplés de manière à ce que, dès l'application d'un courant d'alimentation d'intensité faible, la résistance du nanopilier commence à osciller, c'est-à-dire que l'on ait réalisé un oscillateur magnétique à courant seuil nul, il est nécessaire que les premier et second vortex présentent des polarités opposées. Il est à noter que la chiralité relative des deux vortex détermine simplement le signe du courant d'alimentation propre à exciter un mode magnétique des vortex couplés.

L'empilement des couches du nanopilier 3, couche inférieure, couches constitutives du motif et couche supérieure, est réalisé par des techniques connues de l'homme du métier, telles que la pulvérisation cathodique, l'épitaxie par jets moléculaires ou l'ablation laser puisée.

Le façonnage des couches en disque se fait par des techniques combinant lithographie électronique, lithographie optique, lithographie Laser ou gravure ionique focalisée, suivies d'une technique de gravure qui sont elles aussi connues de l'homme de métier.

En tenant compte du diagramme des types de configuration magnétique rémanente représenté à la figure 3, les première et seconde couches du motif 4 sont préparées de manière à présenter une configuration magnétique rémanente en vortex.

Les première et seconde couches magnétiques sont, de plus, préparées de manière à ce que la polarité du vortex de la première couche soit opposée à celle du vortex de la seconde couche. Un moyen simple pour contrôler la polarité du coeur du vortex d'une couche consiste à appliquer un champ magnétique orienté dans la direction de l'axe A de la couche lors de la phase de préparation.

Lors de la préparation des première et seconde couches ferromagnétiques, la chiralité des vortex peut être contrôlée par l'application d'un courant de reversement adapté. L'intensité du courant de renversement de la chiralité dépend de l'épaisseur de la couche ferromagnétique. La chiralité des vortex des première et seconde couches détermine le sens de circulation du courant d'alimentation dans le nanopilier nécessaire pour exciter l'oscillation entretenue de la configuration magnétique.

La nature du matériau constitutif de la couche intermédiaire 8, ainsi que l'épaisseur de celle-ci, sont ajustées pour adapter l'amplitude du couplage magnétique entre les coeurs des vortex des première et deuxième couches. Il faut que cette interaction soit suffisamment forte par rapport aux forces, source du confinement, pour qu'il existe un décalage entre les deux coeurs à la rémanence.

En variante, alors que dans le mode de réalisation préféré présenté ci-dessus en détail l'oscillateur comporte deux vortex, en variante, la configuration magnétique rémanente de chacune des première et seconde couches correspond à une configuration fortement non-uniforme qui présente une composante hors du plan de la couche considérée.

Un procédé d'utilisation de l'oscillateur magnétique venant d'être présenté comporte l'étape consistant à appliquer un courant d'alimentation à travers le nanopilier, dont l'intensité aura été réglée de manière à conduire à une densité de courant à travers la section transversale du nanopilier entre 0 et environ $1.10^8$ A/cm$^2$. De ce fait, la résistance du nanopilier oscille de manière à générer un signal de puissance dont la fréquence caractéristique est entre 0 et 1 ou 2 GHz, en fonction notamment de la taille des couches ferromagnétiques.

L'oscillateur magnétique selon l'invention présente les avantages suivants :

- L'excitation des modes gyrotropiques de la paire de vortex est possible à courant d'excitation seuil nul.
- L'excitation de ces modes gyrotropiques de la paire de vortex est possible à champ magnétique appliqué nul.
- La dépendance de la fréquence de cet oscillateur magnétique en fonction de l'intensité du courant d'alimentation appliqué présente, en partant d'un courant appliqué nul, une très forte variation, comme l'illustre la courbe de la figure 6. A titre d'exemple pour les paramètres choisis pour la figure 6, alors que l'intensité du courant conduit à une densité de courant dans le nanopilier entre 0 et $1.10^7$ A/cm$^2$, la fréquence d'émission de l'oscillateur varie entre 0 et 0,6 GHz.

- La variation de la fréquence en fonction de la densité du courant d'alimentation à travers une section du nanopilier est sensiblement linéaire entre 0 et environ $1.10^7$ A/cm$^2$. Cette dépendance simple entre la fréquence et l'intensité du courant d'alimentation a pour avantage de faciliter le traitement du signal lorsque cet oscillateur magnétique est utilisé dans un dispositif d'émission/réception (modulation de fréquence, boucle à verrouillage de phase, etc.).

- la variation de la fréquence en fonction de la variation d'intensité (df/di) au pied de la courbe de la figure 6 est de l'ordre de 500 MHz/mA. En fonction de la nature des matériaux des différentes couches, de leur dimensions et de leur épaisseur, des variations entre 100 MHz/mA et 1 GHz/mA sont envisagées. L'oscillateur magnétique selon l'invention est ainsi rendu agile sur une plage de fréquences étendue par une variation de l'intensité du courant d'alimentation sur une plage réduite, et ceci sans application d'un champ magnétique extérieur.

- L'oscillateur présente une compacité élevée puisque son volume est de l'ordre de quelques centaines de nm$^3$ à comparer aux quelques $\mu$m$^3$ pour les oscillateurs "ring" ou bien même aux quelques mm$^3$ pour les oscillateurs LC, qui sont les seules technologies compatibles avec l'électronique CMOS et qui sont donc en compétition avec la technologie du présent oscillateur magnétique. En particulier, il n'a pas à intégrer de moyens permettant de plonger le nanopilier dans un champ magnétique extérieur.

Pour améliorer la puissance électrique produite par le nanopilier de l'oscillateur, différentes variantes de réalisations sont envisagées.

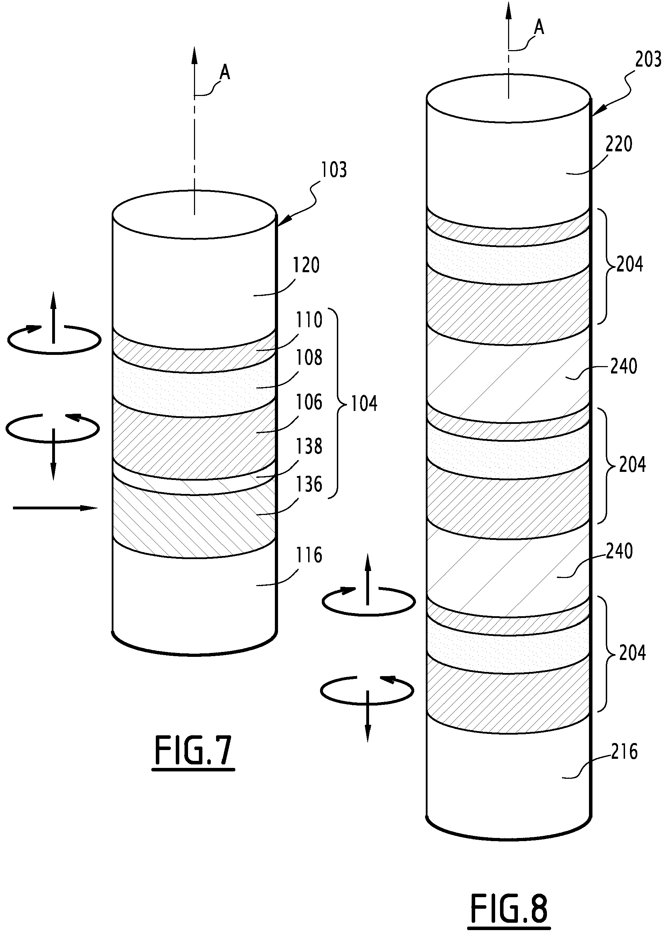

Dans une première variante de l'oscillateur magnétique, représentée à la figure 7, en plus de comporter des première et seconde couches ferromagnétiques 106 et 110, ainsi qu'une couche intermédiaire 108 située entre la première et seconde couches, le motif 104 du nanopilier 103 de cet oscillateur comporte une troisième élément magnétique 136. Cet élément 136 peut être une simple couche ferromagnétique ayant une aimantation fixe et uniforme. Une alternative pour cet élément 136 est un ensemble de deux couches ferromagnétiques couplées par couplage d'échange et biaisées par une couche antiferromagnétique, connu par l'homme du métier sous l'appellation « antiferromagnétique synthétique » (SAF en anglais). Dans tous les cas, ce troisième élément 136 joue le rôle de détecteur.

Favorablement, cette troisième couche magnétique 136 est située au-dessous de la première couche 106 ou au-dessus de la seconde couche 110, le long de l'axe A, et est séparée de celle-ci par une couche de séparation 138. La couche de séparation est réalisée en un matériau magnétique isolant (par exemple MgO ou Al$_2$O$_3$) et a une épaisseur d'environ 1 nm. Cette couche de séparation 138 permet de former une jonction tunnel magnétique, structure connue de l'homme de métier, qui présente des rapports magnétorésistifs tunnel pouvant aller jusqu'à plusieurs centaines de pourcents, à température ambiante. Etant donné que la puissance émise, associée au mouvement de la paire de vortex, est proportionnelle au carré de la variation de la résistance du nanopilier 103, l'amplitude du signal est fortement augmentée par la présence de cette couche de séparation. Le signal peut ainsi atteindre des niveaux de puissance supérieurs au $\mu$W.

Dans une seconde variante, représentée à la figure 8, le motif élémentaire 204 correspondant au motif 4 du nanopilier de la figure 2 (constitué par une première couche ferromagnétique en vortex 6, une couche intermédiaire non magnétique 8 et une seconde couche ferromagnétique en vortex de polarité opposée à celle de la première couche 10) est répété au moins une seconde fois selon la direction A du nanopilier 203. De même, dans une alternative à cette seconde variante, le motif élémentaire qui est répété est constitué par le motif 104 présenté sur la figure 7.

A l'intérieur du nanopilier 203, les motifs sont séparés les uns des autres par une couche de séparation 240. Celle-ci est réalisée en un matériau métallique et présente une épaisseur qui est adaptée de manière à permettre un couplage magnétique ou électrique entre les paires de vortex de chaque motif élémentaire. Ainsi, la répétition d'un motif élémentaire a pour effet de coupler les différentes paires de vortex de chaque motif élémentaire. De la sorte, la largeur de raie autour de la fréquence caractéristique d'oscillation du système constitué par les paires de vortex couplées est réduite.

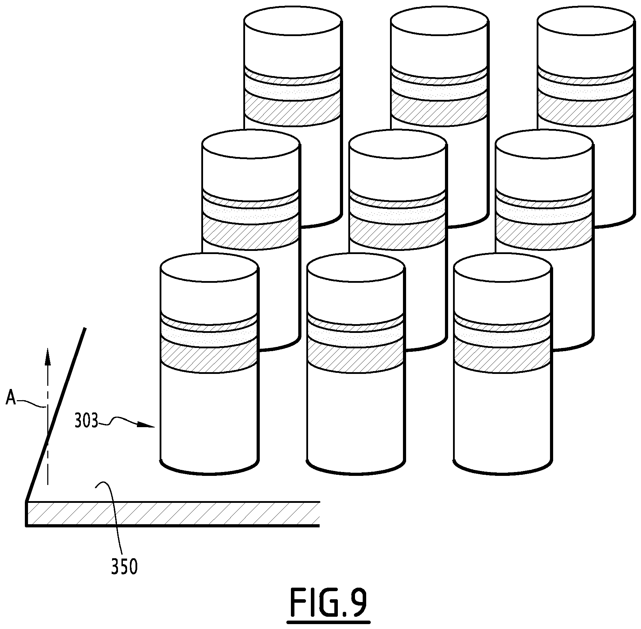

Cet effet de synchronisation entre plusieurs motifs est également obtenu dans une troisième variante représentée à la figure 9, où N nanopiliers 303, chacun identique à celui 3 de la figure 2, celui 103 de la figure 7 ou celui 203 de la figure 8 (ou de leurs variantes), sont disposés périodiquement, sur un même substrat 350 plan, de manière à constituer un réseau à deux dimensions.

Les moyens d'injection d'un courant d'alimentation de cet oscillateur comporte des électrodes permettant de connecter ces différents nanopiliers en parallèle ou en série aux bornes de la source de courant continu (non représentée).

L'invention permet donc de réaliser un oscillateur fortement intégré, compatible avec les technologies CMOS actuelles, présentant un fort facteur de qualité et un courant critique d'alimentation nul, fonctionnant à champ magnétique nul, ainsi qu'une agilité élevée sur une large gamme de fréquences.

L'invention trouve une application particulière dans le domaine des communications sans fil :

- lorsqu'il est intégré dans une chaîne de réception/transmission d'un signal électromagnétique, le présent oscillateur magnétique permet de remplacer un ou plusieurs des composants radiofréquences habituellement utilisés, tels que l'oscillateur local ou le transposeur de fréquences (oscillateur local associé à un mélangeur).

- Avantageusement, étant donnée la multiplication des standards en fréquence pour les télécommunications, le fait que cet oscillateur soit accordable sur une large gamme de fréquences, avec, de manière avantageuse, une forte capacité d'accord df/di et une forte agilité en fréquence (df/dt), permet d'obtenir des dispositifs multistandards et/ou de mieux occuper une bande de fréquences allouée à un standard de communication particulier.

Dans une utilisation possible permettant de réaliser une modulation de la fréquence du signal émis par l'oscillateur, le courant d'alimentation appliqué au nanopilier est modulé à une fréquence faible devant la fréquence caractéristique des oscillations de la résistance du nanopilier.

Dans une autre utilisation, l'oscillateur magnétique est commandé en courant pour être inséré dans une boucle à verrouillage de phase.

L'invention peut également servir à réaliser un mélange de fréquences. Lorsqu'en plus du courant continu d'alimentation permettant de faire varier la résistance à une fréquence caractéristique $f_0$ (associée à la pulsation $\omega_0$), un courant alternatif est injecté à travers le nanopilier, le signal en tension V(t) aux bornes du nanopilier résulte du produit de l'oscillation de la résistance R du nanopilier (autour de la valeur $R_0$) et de l'intensité i(t) de ce courant alternatif :

$$V(t) = (R_0 + \Delta R \cos(\omega_0 t)) * i(t)$$

L'invention réalise alors la fonction « multiplicateur ». Cette fonction peut être utilisée pour réaliser un décalage en fréquence dans le cas par exemple d'un dispositif de démodulation fréquentielle. Notamment, l'application d'un courant alternatif à la fréquence propre du mode magnétique résultera en une modification de la composante continue de la tension aux bornes du nanopilier.

Il est également possible de n'appliquer qu'un courant alternatif à travers le nanopilier. Il est possible, lorsque la fréquence du courant alternatif est proche de la fréquence caractéristique d'un mode du nanopilier, de faire résonner ce mode. Il en résulte une variation de la composante continue de la tension aux bornes du pilier.

Le procédé peut comporter une étape de variation de l'amplitude du courant d'alimentation appliqué à travers le nanopilier, de façon à balayer l'ensemble de la gamme des fréquences caractéristiques de l'oscillateur magnétique, et une étape de mesure, à travers la composante continue de la tension aux bornes du nanopilier, de la densité spectrale d'un signal alternatif pouvant être un courant alternatif ou un champ radiofréquence.

En variante, le courant d'alimentation comporte une composante alternative, et l'utilisation de l'oscillateur comporte une étape d'étude de la composante continue du signal en tension généré aux bornes du nanopilier.

## Revendications

1. Oscillateur magnétique constitué par au moins un nanopilier (3) et des moyens (12) d'injection d'un courant d'alimentation à travers le nanopilier, le nanopilier comportant au moins un motif (4) comprenant des première et seconde couches en un matériau ferromagnétique (6, 10) séparées l'une de l'autre par une couche intermédiaire (8) en un matériau non magnétique, **caractérisé en ce que** la première couche ferromagnétique est préparée de manière à ce que sa configuration magnétique rémanente, pour une amplitude d'un champ magnétique extérieur nulle et une intensité du courant d'alimentation nulle, corresponde à un premier vortex, **en ce que** la seconde couche ferromagnétique est préparée de manière à ce que sa configuration magnétique rémanente, pour une amplitude d'un champ magnétique extérieur nulle et une intensité du courant d'alimentation nulle, corresponde à un second vortex, la composante hors du plan d'une couche de la configuration magnétique de cette couche correspondant à la polarité du vortex, **en ce que** la composante, hors du plan de la première couche, de la configuration magnétique rémanente de la première couche soit opposée à la composante, hors du plan de la seconde couche, de la configuration magnétique rémanente de la seconde couche; et **en ce que** la couche intermédiaire est propre à permettre un couplage magnétique entre les configurations magnétiques des première et seconde couches, même pour une intensité nulle du courant d'alimentation et une amplitude nulle du champ magnétique extérieur, de sorte que des oscillations de la configuration magnétique apparaissent pour toute intensité non nulle du courant d'alimentation.

2. Oscillateur magnétique selon la revendication 1, **caractérisé en ce que** la fréquence caractéristique des oscillations de la configuration magnétique et, par conséquent, de la résistance du nanopilier (3) est sélectionnée dans la gamme de 0 à environ 1 GHz, en fonction de l'intensité du courant d'alimentation et/ou des tailles des première et seconde couches ferromagnétiques.

3. Oscillateur magnétique selon l'une quelconque des revendications précédentes, **caractérisé en ce que** l'intensité du courant d'alimentation délivrée par les moyens d'injection correspond à une densité de courant à travers une section transversale du nanopilier entre 0 et environ $1.10^8$ A/cm$^2$.

4. Oscillateur magnétique selon l'une quelconque des revendications précédentes, **caractérisé en ce que** la variation de la fréquence propre des oscillations de la résistance du nanopilier (3) en fonction de la variation de la densité du courant d'alimentation, est entre 10 et 1000 Hz.A$^{-1}$.cm$^2$

5. Oscillateur magnétique selon l'une quelconque des revendications précédentes, **caractérisé en ce que** le matériau ferromagnétique de la première couche (6) et/ou celui de la seconde couche (10) sont choisis dans le groupe comportant le fer, le cobalt, le nickel et leurs alliages, ainsi que les oxydes magnétiques, les matériaux de Heusler et les semi-conducteurs magnétiques

6. Oscillateur magnétique selon l'une quelconque des revendications précédentes, **caractérisé en ce que** le matériau non magnétique de la couche intermédiaire (8) est choisi dans le groupe comportant le cuivre, l'or et les oxydes d'aluminium, de magnésium et de titane.

7. Oscillateur magnétique selon l'une quelconque des revendications précédentes, **caractérisé en ce que** la première couche (6) a une épaisseur entre 0,2 et 30 nm, notamment 15 nm ; **en ce que** la couche intermédiaire (8) a une épaisseur entre 0,5 et 20 nm, notamment 10 nm ; et **en ce que** la seconde couche (10) a une épaisseur entre 0,1 et 30 nm, notamment 4 nm.

8. Oscillateur magnétique selon l'une quelconque des revendications précédentes, **caractérisé en ce que** le motif (104) du nanopilier (103) comporte au-dessus de la seconde couche (110) ou au-dessous de la première couche (106), une troisième couche (136) ferromagnétique dont la configuration magnétique correspond à une aimantation fixe et uniforme, séparée de la première ou deuxième couche par une couche de séparation (138) non magnétique, de préférence isolante, formant un jonction tunnel magnétique.

9. Oscillateur magnétique selon l'une quelconque des revendications précédentes, **caractérisé en ce que** le nanopilier est constitué d'un empilement vertical d'un nombre N de motifs (204), chacun des motifs étant séparé du précédent par une couche (240) non magnétique métallique permettant un couplage magnétique ou électrique entre les motifs élémentaires.

10. Oscillateur magnétique selon l'une quelconque des revendications précédentes, **caractérisé en ce que** les moyens d'injection comportent une source de courant réglable et des électrodes pour la connexion des couches inférieure et supérieure du nanopilier aux bornes de ladite source.

11. Oscillateur magnétique selon l'une quelconque des revendications précédentes, **caractérisé en ce qu'**il comporte une pluralité de nanopiliers (303) disposés de manière à former un réseau plan à deux dimensions.

12. Dispositif radiofréquence intégrant un oscillateur, **caractérisé en ce que** ledit oscillateur est conforme à l'un quelconque des oscillateurs définis par les revendications 1 à 11.

13. Procédé mettant en oeuvre un oscillateur magnétique selon l'une quelconque des revendications 1 à 11, **caractérisé en ce qu'**il comporte l'étape consistant à appliquer un courant d'alimentation à travers le ou chaque nanopilier constitutif de l'oscillateur magnétique, courant d'alimentation conduisant à une densité de courant à travers une section transversale d'un ou de chaque nanopilier entre 0 et environ $1.10^8$ A/cm$^2$, de manière à générer une oscillation de la résistance d'un ou de chaque nanopilier à une fréquence caractéristique dans la gamme de 0 et environ 1 GHz.

14. Procédé selon la revendication 13, dans lequel le courant d'alimentation appliqué est modulé, à une fréquence faible devant la fréquence caractéristique des oscillations de la résistance du ou de chaque nanopilier, de façon à réaliser une modulation de fréquence du signal émis par l'oscillateur.

15. Procédé selon la revendication 13, dans lequel l'oscillateur magnétique est commandé en courant pour être inséré dans une boucle à verrouillage de phase.

16. Procédé selon la revendication 13, **caractérisé en ce que** le courant d'alimentation comporte une composante continue et une composante alternative, le signal de tension émis par l'oscillateur étant alors la multiplication de l'intensité de la composante alternative et de l'oscillation de la résistance du ou de chaque nanopilier.

17. Procédé selon la revendication 13, **caractérisé en ce qu'**il comporte une étape de variation de l'amplitude du courant d'alimentation appliqué à travers le nanopilier, de façon à balayer l'ensemble de la gamme des fréquences caractéristiques de l'oscillateur magnétique, et une étape de mesure, à travers la composante continue de la tension aux bornes du nanopilier, de la densité spectrale d'un signal alternatif pouvant être un courant alternatif ou un champ radiofréquence.

18. Procédé selon l'une quelconque des revendications 13 à 17, **caractérisé en ce que** le courant d'alimentation comporte une composante alternative, et **en ce qu'**il comporte une étape d'étude de la composante continue du signal en tension généré aux bornes du nanopilier.


**Patentansprüche**

1. Magnetoszillator, der gebildet ist aus mindestens einer Nanosäule (3) und Mitteln (12) zum Injizieren eines Versorgungsstroms durch die Nanosäule, wobei die Nanosäule mindestens ein Muster (4) aufweist, welches eine erste und eine zweite Schicht eines ferromagnetischen Materials (6, 10) aufweist, die mittels einer Zwischenschicht (8) aus einem nicht-magnetischen Material voneinander getrennt sind, **gekennzeichnet dadurch, dass** die erste ferromagnetische Schicht auf eine Weise erstellt ist, dass ihre remanente magnetische Konfiguration für eine Null-Amplitude eines externen Magnetfeldes und eine Null-Intensität des Versorgungsstroms zu einem ersten Vortex korrespondiert, dadurch, dass die zweite ferromagnetische Schicht auf eine Weise erstellt ist, dass ihre remanente magnetische Konfiguration für eine Null-Amplitude eines externen Magnetfeldes und eine Null-Intensität des Versorgungsstroms zu einem zweiten Vortex korrespondiert, wobei die Komponente aus der Ebene einer Schicht mit der magnetischen Konfiguration dieser Schicht heraus zu der Polarität des Vortex korrespondiert, dadurch, dass die Komponente aus der Ebene der ersten Schicht heraus der remanenten magnetischen Konfiguration der ersten Schicht entgegengesetzt ist zu der Komponente aus der Ebene der zweiten Schicht heraus der remanenten magnetischen Konfiguration der zweiten Schicht, und dadurch, dass die Zwischenschicht imstande ist, eine magnetische Kopplung zwischen den magnetischen Konfigurationen der ersten und der zweiten Schicht zu ermöglichen, auch für eine Null-Intensität des Versorgungsstroms und eine Null-Amplitude des externen Magnetfeldes, sodass Oszillationen der magnetischen Konfiguration für jede Intensität ungleich Null des Versorgungsstroms auftreten.

2. Magnetoszillator gemäß Anspruch 1, **dadurch gekennzeichnet, dass** die charakteristische Frequenz der Oszillationen der magnetischen Konfiguration und infolgedessen des Widerstandes der Nanosäule (3) ausgewählt ist aus dem Bereich von 0 bis etwa 1 GHz, abhängig von der Intensität des Versorgungsstroms und/oder den Ausdehnungen der ersten und der zweiten ferromagnetischen Schicht.

3. Magnetoszillator gemäß irgendeinem der vorherigen Ansprüche, **dadurch gekennzeichnet, dass** die Intensität des Versorgungsstroms, der mittels der Mittel zum Injizieren geliefert wird, zu einer Stromdichte durch einen Querschnitt der Nanosäule zwischen 0 und etwa $1.10^8$ A/cm$^2$ korrespondiert.

4. Magnetoszillator gemäß irgendeinem der vorherigen Ansprüche, **dadurch gekennzeichnet, dass** die Variation der Eigenfrequenz der Oszillationen des Widerstands der Nanosäule (3) in Abhängigkeit von der Variation der Dichte des Versorgungsstroms zwischen 10 und 1000 Hz.A$^{-1}$.cm$^2$ liegt.

5. Magnetoszillator gemäß irgendeinem der vorherigen Ansprüche, **dadurch gekennzeichnet, dass** das ferromagnetische Material der ersten Schicht (6) und/oder dasjenige der zweiten Schicht (10) ausgewählt sind aus der Gruppe, welche Eisen, Kobalt, Nickel und deren Legierungen sowie Magnetoxide, Heusler-Materialien und magnetische Halbleiter aufweist.

6. Magnetoszillator gemäß irgendeinem der vorherigen Ansprüche, **dadurch gekennzeichnet, dass** das nicht-magnetische Material der Zwischenschicht (8) ausgewählt ist aus der Gruppe, welche Kupfer, Gold sowie Oxide von Aluminium, von Magnesium und von Titan aufweist.

7. Magnetoszillator gemäß irgendeinem der vorherigen Ansprüche, **gekennzeichnet dadurch, dass** die erste Schicht (6) eine Dicke zwischen 0,2 und 30 nm, insbesondere 15 nm, hat, dadurch, dass die Zwischenschicht (8) eine Dicke zwischen 0,5 und 20 nm, insbesondere 10 nm, hat, und dadurch, dass die zweite Schicht (10) eine Dicke zwischen 0,1 und 30 nm, insbesondere 4 nm, hat.

8. Magnetoszillator gemäß irgendeinem der vorherigen Ansprüche, **dadurch gekennzeichnet, dass** das Muster (104) der Nanosäule (103) oberhalb der zweiten Schicht (110) oder unterhalb der ersten Schicht (106) eine dritte ferromagnetische Schicht (136) aufweist, deren magnetische Konfiguration zu einer festen und gleichförmigen Magnetisierung korrespondiert und die von der ersten oder der zweiten Schicht mittels einer nicht-magnetischen, vorzugsweise isolierenden, Trennschicht (138) getrennt ist, welche einen magnetischen Tunnelkontakt bildet.

9. Magnetoszillator gemäß irgendeinem der vorherigen Ansprüche, **dadurch gekennzeichnet, dass** die Nanosäule aus einem vertikalen Stapel aus einer Anzahl N von Mustern (204) gebildet ist, wobei jedes der Muster mittels einer nicht-magnetischen metallischen Schicht (240), welche eine magnetische oder elektrische Kopplung zwischen den elementaren Mustern erlaubt, vom Vorherigen getrennt ist.

10. Magnetoszillator gemäß irgendeinem der vorherigen Ansprüche, **dadurch gekennzeichnet, dass** die Mittel zum Injizieren eine einstellbare Stromquelle und Elektroden zum Verbinden einer unteren und einer oberen Schicht der Nanosäule mit den Anschlüssen der besagten Quelle aufweisen.

11. Magnetoszillator gemäß irgendeinem der vorherigen Ansprüche, **dadurch gekennzeichnet, dass** er eine Vielzahl von Nanosäulen (303) aufweist, die auf eine Weise angeordnet sind, um ein ebenes Netz mit zwei Dimensionen zu bilden.

12. Funkfrequenz-Vorrichtung, die einen Oszillator integriert, **dadurch gekennzeichnet, dass** der besagte Oszillator irgendeinem der mittels der Ansprüche 1 bis 11 definierten Oszillatoren entspricht.

13. Verfahren, welches einen Magnetoszillator gemäß irgendeinem der Ansprüche 1 bis 11 einsetzt, **dadurch gekennzeichnet, dass** es den Schritt aufweist, welcher gebildet ist aus dem Anlegen eines Versorgungsstroms durch die oder jede Nanosäule, die Bestandteil des Magnetoszillators ist, wobei der Versorgungsstrom zu einer Stromdichte durch einen Querschnitt einer oder jeder Nanosäule zwischen 0 und etwa $1.10^8$ A/cm$^2$ führt, um eine Oszillation des Widerstands einer oder jeder Nanosäule mit einer charakteristischen Frequenz im Bereich von 0 und etwa 1 GHz zu erzeugen.

14. Verfahren gemäß Anspruch 13, wobei der angelegte Versorgungsstrom mit einer gegenüber der charakteristischen Frequenz der Oszillationen des Widerstands der oder jeder Nanosäule geringen Frequenz moduliert wird, um eine Frequenzmodulation des Signals zu realisieren, welches mittels des Oszillators emittiert wird.

15. Verfahren gemäß Anspruch 13, wobei der Magnetoszillator stromgesteuert wird, um in eine Phasenregelschleife eingefügt zu sein.

16. Verfahren gemäß Anspruch 13, **dadurch gekennzeichnet, dass** der Versorgungsstrom eine Gleichkomponente und eine Wechselkomponente aufweist, wobei das mittels des Oszillators emittierte Spannungssignal folglich die Multiplikation der Intensität der Wechselkomponente und der Oszillation des Widerstands der oder jeder Nanosäule ist.

17. Verfahren gemäß Anspruch 13, **dadurch gekennzeichnet, dass** es aufweist einen Schritt des Variierens der Amplitude des Versorgungsstroms, der durch die Nanosäule angelegt ist, um die Gesamtheit des Bereichs der charakteristischen Frequenzen des Magnetoszillators abzutasten, und einen Schritt des Messens durch die Gleichkomponente der Spannung an den Anschlüssen der Nanosäule der spektralen Dichte eines Wechselsignals, welches ein Wechselstrom oder ein Funkfrequenzfeld sein kann.

18. Verfahren gemäß irgendeinem der Ansprüche 13 bis 17, **dadurch gekennzeichnet, dass** der Versorgungsstrom eine Wechselkomponente aufweist, und dadurch, dass es einen Schritt des Lernens der Gleichkomponente des Spannungssignals, das an den Anschlüssen der Nanosäule erzeugt wird, aufweist.

## Claims

1. A magnetic oscillator made up of at least one nanopillar (3) and means (12) for injecting a power supply current through the nanopillar, the nanopillar including at least one pattern (4) comprising first and second layers made from a ferromagnetic material (6, 10), separated from each other by an intermediate layer (8) made from a non-magnetic material, **characterised in that** the first ferromagnetic layer is prepared such that its residual magnetic configuration, for a zero amplitude of the outside magnetic field and a zero intensity of the power supply current, corresponds to a first vortex, **in that** the second ferromagnetic layer is prepared such that its residual magnetic configuration, for a zero amplitude of the outside magnetic field and a zero intensity of the power supply current, corresponds to a second vortex, the component outside the plane of a layer of the magnetic configuration of that layer corresponding to the polarity of the vortex, **in that** the component, outside the plane of the first layer, of the remnant magnetic configuration of the first layer is opposite to the component, outside the plane of the second layer, of the remanent magnetic configuration of the second layer, and **in that** the intermediate layer is capable of allowing magnetic coupling between the magnetic configurations of the first and second layers, even for a zero intensity of the power supply current and a zero amplitude of the outside magnetic field, such that oscillations of the magnetic configuration appear for any non-zero intensity of the power supply current.

2. The magnetic oscillator according to claim 1, **characterised in that** the characteristic frequency of the oscillations of the magnetic configuration and, consequently, of the resistance of the nanopillar (3) is in the range of 0 to approximately 1 GHz, as a function of the intensity of the power supply current and/or the sizes of the first and second ferromagnetic layers.

3. The magnetic oscillator according to any one of the preceding claims, **characterised in that** the intensity of the power supply current delivered by the injection means corresponds to a current density through a transverse section of the nanopillar between 0 and approximately $1.10^8$ A/cm$^2$.

4. The magnetic oscillator according to any one of the preceding claims, **characterised in that** the variation of the characteristic frequency of the magnetic oscillations of the resistance of the nanopillar (3) according to the variation of the density of the power supply current is between 10 and 1000 Hz.A$^{-1}$.cm$^2$.

5. The magnetic oscillator according to any one of the preceding claims, **characterised in that** the ferromagnetic material of the first layer (6) and/or the ferromagnetic material of the second layer (10) are chosen from the group including iron, cobalt, nickel and alloys thereof, as well as magnetic oxides, Heusler materials and magnetic semiconductors.

6. The magnetic oscillator according to any one of the preceding claims, **characterised in that** the non-magnetic material of the intermediate layer (8) is chosen in the group including copper; gold; and aluminum, magnesium and titanium oxides.

7. The magnetic oscillator according to any one of the preceding claims, **characterised in** the first layer (6) has a thickness between 0.2 and 30 nm, in particular 15 nm; **in that** the intermediate layer (8) has a thickness between 0.5 and 20 nm, in particular 10 nm; and **in that** the second layer (10) has a thickness between 0.1 and 30 nm, in particular 4 nm.

8. The magnetic oscillator according to one of the preceding claims, **characterised in that** the pattern (104) of the nanopillar (103) includes, above the second layer (110) or below the first layer (106), a third ferromagnetic layer (136) whereof the magnetic configuration corresponds to a fixed and uniform magnetization, separated from the first or second layer by a non-magnetic separating layer (138), preferably insulating, forming a magnetic tunnel junction.

9. The magnetic oscillator according to any one of the preceding claims, **characterised in that** the nanopillar is made up of a vertical stack of a number N of patterns (204), each of the patterns being separated from the previous one by a metal non-magnetic layer (240) allowing a magnetic or electric coupling between the elementary patterns.

10. The magnetic oscillator according to any one of the preceding claims, **characterised in that** the injection means include an adjustable current source and electrodes for connecting the lower and upper layers of the nanopillar across the terminals of said source.

11. The magnetic oscillator according to any one of the preceding claims, **characterised in that** it includes multiple nanopillars (303) positioned so as to form a planar two-dimensional array.

12. A radiofrequency device integrating an oscillator, **characterised in that** said oscillator is according to any one of the oscillators defined by claims 1 to 11.

13. A method implementing a magnetic oscillator according to any one of claims 1 to 11, **characterised in that** it includes a step consisting of applying a power supply current through the or each nanopillar making up the magnetic oscillator, the power supply current leading to a current density through a transverse section of one or each nanopillar between 0 and approximately $1.10^8$ A/cm$^2$, so as to generate an oscillation of the resistance of one or each nanopillar at the characteristic frequency in the range from 0 to approximately 1 GHz.

14. The method according to claim 13, wherein the applied power supply current is modulated, at a low frequency relative to the characteristic frequency of the oscillations of the resistance of the or each nanopillar, so as to produce a frequency modulation of the signal emitted by the oscillator.

15. The method according to claim 13, wherein the magnetic oscillator is current controlled, in order to be inserted into a phase locked loop.

16. The method according to claim 13, **characterised in that** the power supply current includes a direct component and an alternating component, the voltage signal emitted by the oscillator being the product of the intensity of the alternating component with the oscillation of the resistance of the or each nanopillar.

17. The method according to claim 13, **characterised in that** it includes a step for varying the amplitude of the power supply current applied to the nanopillar, so as to scan all of the range of characteristic frequencies of the magnetic oscillator, and a step for using the direct component of the voltage across the terminals of the nanopillar to measure the spectral density of an alternating signal that may be an alternating current or radiofrequency field.

18. The method according to any one of claims 13 to 17, **characterised in that** the power supply current includes an alternating component, and **in that** it includes a step for studying the direct component of the voltage signal generated across the terminals of the nanopillar.

C = +1
P = +1

C = +1
P = -1

C = -1
P = +1

C = -1
P = -1

## FIG.1

## FIG.2

## FIG.3

FIG.4

FIG.5

FIG.6

FIG.7

FIG.8

FIG.9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20090117370 A1

**Littérature non-brevet citée dans la description**

- Dynamics of two coupled vortices in a spin valve nanopillar excited by spin transfer torque. **LOCATELLI et al.** APPLIED PHYSICS LETTERS. AIP, AMERICAN INSTITUTE OF PHYSICS, 07 Février 2011, vol. 98, 62501-62501
- Direct observation of antiferromagneticaliy oriented spin vortex states in magnetic multilayer elements. **WINTZ et al.** APPLIED PHYSICS LETTERS. AIP, AMERICAN INSTITUTE OF PHYSICS, 09 Juin 2011, vol. 98, 232511-232511
- Nonlinear motion of coupled magnetic vortices in ferromagnetic/nonmagnetic/ferromagnetic trilayer. **SU-HYEONG et al.** APPLIED PHYSICS LETTERS. A I P PUBLISHING LLC, 09 Octobre 2009, vol. 95, 142509-142509
- **BUERGLER et al.** Injection locking of single-vortex and double-vortex spin-torque oscillators. *PROCEEDINGS OF SPIE,* 01 Janvier 2011, 810018-810018, 9